Europäisches Patentamt

European Patent Office

Office européen des brevets

(11) Numéro de publication: **0 024 970**
**B1**

(12) **FASCICULE DE BREVET EUROPEEN**

(45) Date de publication du fascicule du brevet: **28.03.84**

(21) Numéro de dépôt: **80401158.3**

(22) Date de dépôt: **06.08.80**

(51) Int. Cl.³: **H 01 L 27/14**

(54) Procédé de fabrication d'un dispositif photodétecteur à semiconducteur.

(30) Priorité: **31.08.79 FR 7921903**

(43) Date de publication de la demande:
**11.03.81 Bulletin 81/10**

(45) Mention de la délivrance du brevet:
**28.03.84 Bulletin 84/13**

(84) Etats contractants désignés:
**DE GB**

(73) Titulaire: **THOMSON-CSF**
**173, Boulevard Haussmann**
**F-75379 Paris Cedex 08 (FR)**

(72) Inventeur: **Reboul, Jean Philippe**
**"THOMSON-CSF" - SCPI 173,Bld Haussmann**
**F-75360 Paris Cedex 08 (FR)**
Inventeur: **Villard, Michel**
**"THOMSON-CSF" - SCPI 173,Bld Haussmann**
**F-75360 Paris Cedex 08 (FR)**

(74) Mandataire: **Ruellan, Brigitte et al,**
**THOMSON-CSF SCPI 173, boulevard Haussmann**
**F-75379 Paris Cedex 08 (FR)**

(56) Documents cités:
**FR - A - 1 578 110**
**FR - A - 2 079 612**
**FR - A - 2 080 849**
**FR - A - 2 198 257**
**US - A - 3 864 818**

**IBM TECHNICAL DISCLOSURE BULLETIN,**
**volume 7, no. 10, mars 1965, NEW YORK (US),**
**M.M. ROY et al. "Optically driven switch reduced**
**turnoff time", pages 962-963**

Courier Press, Leamington Spa, England.

Procédé de fabrication d'un dispositif photodétecteur à semiconducteur

La présente invention a pour objet un procédé de fabrication d'un dispositif semi-conducteur de détection d'un rayonnement électromagnétique incident, dont la longueur d'onde se situe dans le domaine de la lumière visible, de l'infra-rouge ou de l'ultra-violet.

Un tel détecteur, appelé dans toute la suite, pour simplifier, photodétecteur, est généralement constitué par un réseau de jonctions réalisé sur une surface d'une plaquette semiconductrice; chaque jonction constitue la surface électriquement active de détection et comporte de part et d'autre des contacts électriques.

Dans certaines applications, notamment pour améliorer le pouvoir de résolution, on est conduit à diminuer les dimensions des photodétecteurs élémentaires, c'est-à-dire des jonctions, celles-ci pouvant atteindre quelques dizaines de micromètres. A ce moment, on constate un effet de bord, c'est-à-dire que la zone sur laquelle le rayonnement incident produit ses effets devient sensiblement supérieure à la surface de la jonction détectrice proprement dite, ce quie limite la dimension minimale des zones de détection que l'on peut obtenir.

Il est connu de limiter cet effet de bord par un écran opaque au rayonnement incident, cet écran étant disposé à la périphérie de chacun des photodétecteurs élémentaires. Toutefois, dans le cas ou les photodétecteurs sont constitués par des diodes de type mésa, la zone périphérique des diodes n'est pas plane et l'écran ne peut, de ce fait, être placé très près des jonctions: il ne joue donc qu'imparfaitement son rôle et l'amélioration qu'il apporte n'est pas suffisante pour éviter complètement l'effet de bord.

La présente invention a pour objet un procédé de fabrication d'un dispositif photodétecteur permettant d'éviter ces inconvénients. Plus précisément, le dispositif selon l'invention comporte un réseau de détecteurs élémentaires réalisés dans un substrat semiconducteur (1), et, disposée entre les détecteurs élémentaires et sur le substrat (1), une couche (5) d'un matériau opaque au rayonnement incident.

L'invention a donc pour objet un procédé de fabrication d'un tel dispositif, qui comporte principalement les étapes suivantes:

— la réalisation sur un substrat semiconducteur (1) d'une zone de jonction sur toute la surface du substrat;
— le dépôt d'une couche protectrice (3) sur les zones destinées à constituer les détecteurs élémentaires;
— la gravure de sillons (4) entre les zones précédentes;
— le dépot par évaporation d'une couche (5) mince opaque sur l'ensemble de la surface du dispositif;
— l'élimination de la couche protectrice (3);
— la réalisation de contacts électriques (6) sur chacun des détecteurs élémentaires et sur le substrat, et de connexions (7) sur ces contacts.

D'autres objets, caractéristiques et résultats de l'invention ressortiront de la description suivante, donnée à titre d'exemple non limitatif et illustrée par les figures annexées 1 à 5 qui représentent les différentes étapes du procédé selon l'invention, dans le cas où les détecteurs élémentaires sont constitués par des photodiodes du type mésa.

Sur ces différentes figures, d'une part les mêmes références se rapportent aux mêmes éléments et, d'autre part, l'échelle réelle n'est pas respectée pour une plus grande clarté.

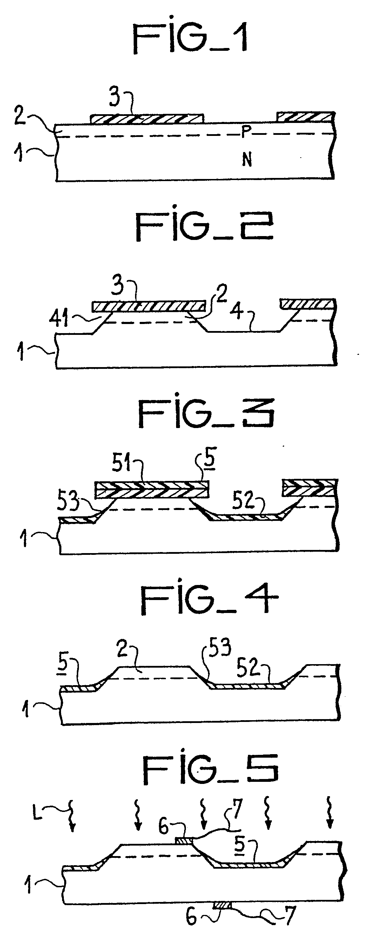

La figure 1 représente un substrat 1 semi-conducteur, choisi en fonction du rayonnement incident à détecter (visible infra-rouge ou ultra violet) et qui peut par exemple, dans le cas de l'infra-rouge, avoir l'une des formules chimiques suivantes:

$$In\ Sb,\ Si,\ Pb_{1-x}\ Sn_x\ Te,\ Cd_{1-x}\ Hg_x\ Te.$$

Sur toute la surface du substrat 1 a été réalisée une jonction, par exemple par diffusion dans une couche 2 d'impuretés du type P si le substrat est de type N.

La seconde étape du procédé consiste à délimiter, dans la couche 2 et le substrat 1, des zones de jonction séparées les unes des autres, qui constitueront les photodétecteurs élémentaires. Selon un procédé classique, on dépose sur la couche 2 une laque, ou résine, photosensible 3 sur les surfaces qui constitueront les photodiodes après l'étape de gravure ci-après.

Selon une variante, non représentée, on procède selon la technique dite du contre-masquage, qui consiste:

— à déposer un matériau servant de masque sur les surfaces qui ne constitueront pas les diodes;
— à déposer une couche protectrice (mobybdène par exemple) sur l'ensemble de la surface sur une épaisseur de quelques micromètres;
— puis à enlever le masque précédent, laissant ainsi subsister le mobybdène sur les surfaces qui constitueront les diodes.

La figure 2 représente l'étape suivante dans laquelle on a réalisé des sillons 4 entre les zones protégées par la couche de laque 3. La gravure de ces sillons peut être faite par exemple par attaque chimique; elle doit s'étendre sur une profondeur supérieure à celle de la couche 2, afin d'isoler les diodes mésa les unes par rapport aux autres. Une telle gravure pénètre légèrement sous la couche 3, comme représentée sur la figure 2 (zone 41), sur une distance qui peut être de l'ordre de quelques micromètres, selon le phénomène bien connu de sous-gravure. On obtient donc au terme de cette étape une surface de jonction plus petite que la zone protégée par la couche 3, qui forme un cadre débordant.

Dans l'étape suivante, représentée sur la figure 3, on dépose une couche mince 5, choisie pour être opaque au rayonnement à détecter. Le dépôt de cette couche 5 est fait sur l'ensemble du dispositif, de préférence à l'aide d'un évaporateur directif, constitué par exemple par une enceinte à vide élevé possédant une source d'évaporation de petites dimensions. Ainsi qu'il est représenté sur la figure 3, cette couche mince, qui peut être d'une épaisseur d'environ 1/10ème de micromètre, se décompose au niveau de chaque photodétecteur élémentaire en trois parties: une partie 51 qui recouvre la couche 3; une partie 52 qui vient recouvrir le fond des sillons 4, et enfin une partie 53 qui prolonge la partie 52 et remonte le long des flancs du sillon 4 jusqu'à recouvrir éventuellement légèrement la zone de jonction, mais sans atteindre la couche 3 du fait de la géométrie au cadre débordant de celle-ci, cet effet de protection étant plus ou moins accentué selon que le phénomène de sous-gravure est lui-même plus ou moins accentué. Du fait qu'une partie (la partie 53) de la couche 5 est susceptible de s'étendre de part et d'autre d'une jonction, selon une épaisseur dépendant des conditions de son dépôt, il est préférable que cette couche 5 soit en un matériau isolant pour éviter que la jonction ne se trouve court-circuitée; cette couche peut être par exemple constituée par un isolant chargé de particules opaques.

Dans l'étape suivante, représentée figure 4, on procède à l'élimination des couches 3 et 51 qui recouvrent les jonctions. Cette élimination peut être réalisée selon la technique dite du "lift off", consistant à dissoudre la couche de laque 3 puis soulever le matériau 51 déposé sur cette couche. Il ne subsiste alors que les parties 52 et 53 de la couche 5, constituant l'écran recherché.

Les étapes suivantes sont classiques et ne seront donc pas décrites en détail; elles sont illustrées figure 5 et consistent à déposer les contacts électriques 6 sur chacune des diodes et sur le substrat, et les connexions 7 sur ces contacts. Le rayonnement incident L est reçu sur la face du substrat 1 qui porte les diodes.

Bien entendu, la description qui précède n'a été faite qu'à titre d'exemple et différentes variantes sont possibles, parmi lesquelles on peut citer notamment:

— la réalisation de la gravure des jonctions mésa par une autre méthode: usinage ionique ou gravure par plasma par exemple;

— le remplacement de la couche 5 unique par deux couches superposées, la première, déposée sur le substrat, étant isolante électriquement et la seconde étant opaque;

— la réalisation de la couche 5 par un matériau soit réfléchissant soit absorbant le rayonnement incident;

— l'arrangement des photodétecteurs élémentaires selon un réseau linéaire (à une dimension) ou surfacique (à deux dimensions);

— l'interposition d'une couche isolante, réalisée dans une étape se situant entre le schéma de la figure 4 et celui de la figure 5, recouvrant l'ensemble du dispositif sauf les points où doivent être réalisés les contacts 6.

Un procédé de réalisation d'un dispositif tel que décrit ci-dessus permet donc de disposer d'un réseau photodétecteur à haute résolution et faible diaphotie.

Il est notamment applicable à l'analyse d'image reçue en lumière infrarouge ou visible.

**Revendications**

1. Procédé de fabrication d'un dispositif photodétecteur à semiconducteur comportant un réseau de détecteurs élémentaires constitués de diodes mésa réalisés dans un substrat semiconducteur caractérisé en ce qu'il comporte les étapes suivantes:

— la réalisation sur un substrat semiconducteur (1) d'une zone de jonction sur toute la surface du substrat;

— le dépôt d'une couche protectrice (3) sur les zones destinées à constituer les détecteurs élémentaires;

— la gravure de sillons (4) entre les zones précédentes;

— le dépôt par évaporation d'une couche (5) opaque sur l'ensemble de la surface du dispositif;

— l'élimination de la couche protectrice (3);

— la réalisation de contacts électriques (6) sur chacun des détecteurs élémentaires et sur le substrat, et de connexions (7) sur ces contacts.

2. Procédé selon la revendication 1 caractérisé en ce que, après la gravure des sillons, on réalise tout d'abord sur le substrat une couche électriquement isolante, la couche opaque étant déposée sur la couche isolante.

3. Procédé selon la revendication 1 caractérisé en ce que la couche opaque (5) est constituée par un matériau opaque et électriquement isolant.

**Patentansprüche**

1. Herstellungsverfahren einer Halbleiterphotodetektorvorrichtung, welche ein Netz von Elementardetektoren enthält, die aus in einem Halbleitersubstrat gebildeten Mesadioden bestehen, dadurch gekennzeichnet, dass es folgende Verfahrensschritte beinhaltet:

— das Schaffen auf einem Halbleitersubstrat (1) einer Verbindungszone auf der gesamten Oberfläche des Substrats;
— das Auftragen einer Schutzschicht auf die Zonen, die dazu bestimmt sind die Elementardetektoren zu bilden;
— das Gravieren von Rillen (4) zwischen die vorgenannten Zonen;
— das Auftragen durch Verdampfen einer lichtundurchlässigen Schicht (5) auf die Gesamtheit der Oberfläche der Vorrichtung;
— das Entfernen der Schutzschicht (3);
— das Schaffen von elektrischen Kontakten (6) auf jedem der Elementardetektoren und auf dem Substrat, und von Anschlüssen (7) auf diesen Kontakten.

2. Verfahren nach Anspruch 1, dadurch gekennzeichnet, dass man nach der Gravierung der Rillen zuerst auf dem Substrat eine elektrisch isolierende Schicht schafft, wobei die lichtundurchlässige Schicht auf der isolierenden Schicht aufgetragen wird.

3. Verfahren nach Anspruch 1, dadurch gekennzeichnet, dass die lichtundurchlässige Schicht (5) von einem lichtundurchlässigen und elektrisch isolierenden Material gebildet wird.

**Claims**

1. A process for the manufacture of a semiconductor photodetector device comprising a network of elementary detectors constituted by mesa diodes realized in a semiconductor substrate, characterized in that it comprises the following steps:

— the realization on a semiconductor substrate (1) of a junction zone on the whole surface of the substrate;
— the deposit of a protective layer (3) on the zones destined to constitute the elementary detectors;
— the engraving of grooves (4) between the preceding zones;
— the deposit by evaporation of an opaque layer (5) on the whole of the surface of the device;
— the elimination of the protective layer (3);
— the realization of electric contacts (6) on each of the elementary detectors and on the substrate, and the connections (7) on these contacts.

2. A process according to claim 1, characterized in that, after engraving the grooves, is first of all realized on the substrate an electrically insulating layer, the opaque layer being deposited on the insulating layer.

3. A process according to claim 1, characterized in that the opaque layer is constituted by an opaque and electrically insulating material.

## FIG_1

## FIG_2

## FIG_3

## FIG_4

## FIG_5